# EUROPEAN PATENT SPECIFICATION

(11) **EP 4 310 159 B1**
(45) Date of publication and mention of the grant of the patent: **06.11.2024**
(21) Application number: 22200727.0
(22) Date of filing: 11.10.2022
(51) Int. Cl.: C09K 19/38, C09K 19/52, C09K 19/54, B32B 15/08, H05K 1/03

(54) **HIGH DIELECTRIC LIQUID CRYSTAL POLYMER COMPOSITE MATERIAL AND PREPARATION METHOD THEREOF**
HOCHDIELEKTRISCHES FLÜSSIGKRISTALLPOLYMERVERBUNDMATERIAL UND HERSTELLUNGSVERFAHREN DAFÜR
MATÉRIAU COMPOSITE POLYMÈRE À CRISTAUX LIQUIDES À CONSTANTE DIÉLECTRIQUE ÉLEVÉE ET SON PROCÉDÉ DE PRÉPARATION

(30) Priority: 22.07.2022 CN 202210866776
(43) Date of publication of application: 24.01.2024
(73) Proprietor: Ningxia Qingyan Polymer Materials Co., Ltd., 753000 Ningxia Hui Autonomous Region (CN)
(72) Inventor: YU, Ran, Ningxia Hui Autonomous Region (CN); ZHANG, Dongbao, Ningxia Hui Autonomous Region (CN); XU, Liang, Ningxia Hui Autonomous Region (CN); LE, Zewei, Ningxia Hui Autonomous Region (CN); Chen, Rongqiang, Ningxia Hui Autonomous Region (CN); Zhang, Jian, Ningxia Hui Autonomous Region (CN); SHAO, Caiping, Ningxia Hui Autonomous Region (CN)
(74) Representative: Sach, Greg Robert

(56) References cited:
- CN-A- 110 769 594

## Description

### TECHNICAL FIELD

The present application relates to the technical field of polymer materials, and in particular, to a high dielectric liquid crystal polymer composite material and a preparation method thereof.

### BACKGROUND

With the continuous breakthrough of science and technology, the electrical and electronic industry has developed rapidly. Lightweight, miniaturization and integration are the future development trends of electronic products. As an important part of electrical components, capacitors are widely used in electronic equipment, communication equipment and other pulse power equipment. Size and efficiency of capacitors are critical to the entire process, and high dielectric polymer-based composite materials, see for instance CN 110 769 594 A, are an important way to miniaturize capacitors.

Conventional high dielectric materials are typically inorganic ceramic materials (such as barium titanate, copper calcium titanate, and zirconium titanate). Although these materials have very high dielectric constants, they also have a problem of high dielectric loss.

### SUMMARY

Embodiments of the present application provide a high dielectric liquid crystal polymer composite material and a preparation method thereof, so as to solve the technical problem of high dielectric loss in the existing high dielectric polymer composite material.

In a first aspect, embodiments of the present application provide a high dielectric liquid crystal polymer composite material, characterized by comprising liquid crystal polymer (LCP); poly(vinylidene fluoride-co-hexafluoropropylene); modified multi-walled carbon nanotubes; and modified dielectric ceramics;
wherein the modified multi-walled carbon nanotubes comprise following components metered by mass: 0.5∼2 parts of multi-walled carbon nanotubes; 1∼4 parts of polyvinyl pyrrolidone; and 1.5∼5 parts of a silane coupling agent; and
wherein the modified dielectric ceramics comprise following components metered by mass: 10∼20 parts of dielectric ceramics; and 1~2 parts of a dopa-like compound.

In some embodiments, the silane coupling agent comprises at least one of vinylmethyldimethoxysilane, 3-(methacryloyloxy)propyltrimethoxysilane, and 3-mercaptopropyltrimethoxysilane.

In some embodiments, the dielectric ceramics comprise at least one of barium titanate, strontium titanate and calcium titanate.

In some embodiments, the dopa-like compound comprises at least one of dopa, dopamine and dopamine hydrochloride.

In some embodiments, the liquid crystal polymer is wholly aromatic liquid crystal polymer.

In some embodiments, a mass ratio of the liquid crystal polymer, the poly(vinylidene fluoride-co-hexafluoropropylene), the modified multi-walled carbon nanotubes and the modified dielectric ceramics is (20-35) : (14-16) : (1-4) : (10-20).

In a second aspect, embodiments of the present application provide a preparation method of the high dielectric liquid crystal polymer composite material described in the first aspect, characterized by comprising:
obtaining modified multi-walled carbon nanotubes;
obtaining modified dielectric ceramics;
dissolving poly(vinylidene fluoride-co-hexafluoropropylene) into a first solvent to obtain a first solution;
dissolving the modified multi-walled carbon nanotubes and the modified dielectric ceramics into a second solvent to obtain a second solution;
adding the first solution into the second solution and mixing by stirring to obtain a third solution;
adding liquid crystal polymer (LCP) into the third solution and mixing by stirring to obtain a fourth solution; and
performing washing the fourth solution by adding the fourth solution into water, then performing drying and hot press molding, so as to obtain the high dielectric liquid crystal polymer composite material.

In some embodiments, the obtaining modified multi-walled carbon nanotubes comprises specifically:
adding multi-walled carbon nanotubes into a third solvent to obtain a fifth solution;
adding polyvinyl pyrrolidone (PVP) into a fourth solvent to obtain a sixth solution;
adding the fifth solution into the sixth solution, then performing sealing and centrifuging at room temperature to obtain a first precipitate;
adding a silane coupling agent into a fifth solvent and adjusting pH to 9∼10 to obtain a seventh solution;
adding the first precipitate into the seventh solution, then performing stirring and centrifuging to obtain a second precipitate; and
washing the second precipitate, and then performing drying and grinding to obtain the modified multi-walled carbon nanotubes.

In some embodiments, the obtaining modified dielectric ceramics comprises specifically:
adding dielectric ceramics into a Tris buffer to obtain an eighth solution;
adding a dopa-like compound into the eighth solution, adjusting pH to 8∼9 and then performing a sonication treatment in an ice bath for 8~15 min to obtain a ninth solution;
stirring the ninth solution at room temperature for 10∼24 h, then performing vacuum suction filtration, washing and drying to obtain dielectric ceramics with core-shell structure;
dispersing the dielectric ceramics with core-shell structure in water, and then performing a sonication treatment in an ice bath for 0.5∼1 h to obtain a tenth solution; and
adding an AgNO₃ solution into the tenth solution, then stirring in an ice bath for 1∼2 h and performing centrifuging, washing and drying to obtain the modified dielectric ceramics.

In some embodiments, working parameters of the hot press molding comprise a temperature of 300°C to 350°C and a pressure of 10 MPa to 15 MPa.

Compared with the prior art, the above-mentioned technical solutions provided in the embodiments of the present application have the following advantages.

The embodiments of the present application provides a high dielectric liquid crystal polymer composite material, which is formed by complexing liquid crystal polymer with poly(vinylidene fluoride-co-hexafluoropropylene), modified multi-walled carbon nanotubes and modified dielectric ceramics. Since there is an obvious enhanced synergistic effect between the different fillers, the liquid crystal polymer composite material with both high dielectric properties and low dielectric loss is obtained. Specifically, the organosilane coupling agent improves the compatibility between the multi-walled carbon nanotubes and the matrix, making them evenly dispersed, and reduces the percolation threshold due to grafting of an insulating layer on the surface thereof; since the surface of the dielectric ceramic is coated with a polydopamine layer, the hydrogen bond between the PDA shell and the fluoropolymer greatly enhances the interfacial adhesion of the nanocomposite, meanwhile the Coulomb shielding effect of silver nanoparticles is successfully introduced; and by utilizing the synergy between the two modified fillers, the liquid crystal polymer composite material has the characteristics of low dielectric loss while ensuring high dielectric properties, which effectively solves the technical problem of high dielectric loss in existing high dielectric polymer composite materials.

### BRIEF DESCRIPTION OF THE DRAWINGS

The accompanying drawings, which are incorporated in and constitute a part of the specification, illustrate embodiments consistent with the present application and, together with the description, serve to explain the principles of the present application.

In order to illustrate the embodiments of the present application or the technical solutions in the prior art more clearly, the following briefly introduces the accompanying drawings that are required in the description of the embodiments or the prior art. Obviously, for those of ordinary skill in the art, other drawings can also be obtained from these drawings without any creative effort.

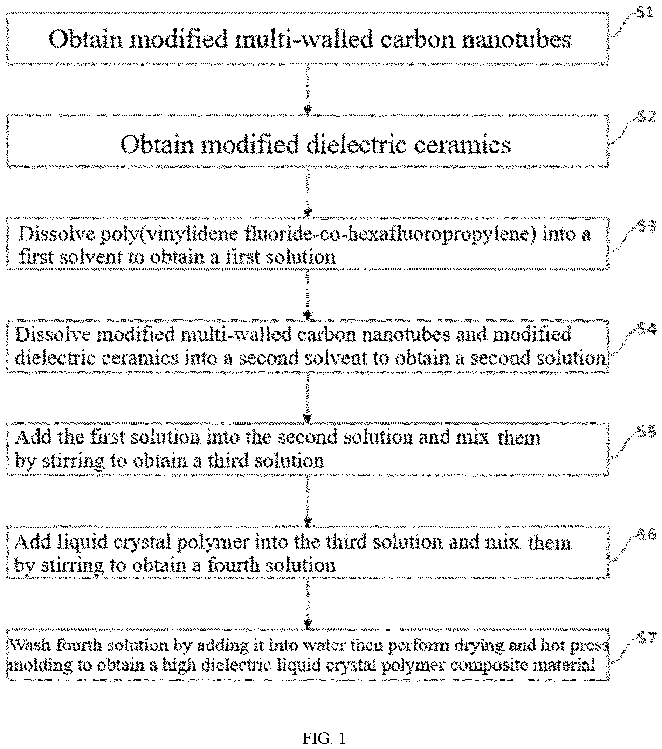

FIG. 1 is a schematic flowchart of a preparation method of a high dielectric liquid crystal polymer composite material according to some embodiments of the present application.

### DETAILED DESCRIPTION OF THE INVENTION

The present application will be described in detail below with reference to specific embodiments and examples, and the advantages and various effects of the present application will be more clearly presented thereby. It should be understood by those skilled in the art that these specific embodiments and examples are used to illustrate, but not to limit, the present application.

Throughout the specification, unless specifically stated otherwise, terms used herein are to be understood as commonly used in the art. Therefore, unless otherwise defined, all technical and scientific terms used herein have the same meaning as commonly understood by one of ordinary skill in the art to which the present application belongs. In case of conflict, the present specification takes precedence.

Unless otherwise specified, various raw materials, reagents, instruments and device used in the present application are commercially available or can be prepared by existing methods.

With the continuous breakthrough of science and technology, the electrical and electronic industry has developed rapidly. Lightweight, miniaturization and integration are the future development trends of electronic products. As an important part of electrical components, capacitors are widely used in electronic equipment, communication equipment and other pulse power equipment. Size and efficiency of capacitors are critical to the entire process, and high dielectric polymer-based composite materials are an important way to miniaturize capacitors.

Conventional high dielectric materials are typically inorganic ceramic materials (such as barium titanate, copper calcium titanate, and zirconium titanate). Although these materials have very high dielectric constants, they also have the problem of high dielectric loss.

The technical solutions provided by the embodiments of the present application are to solve the above-mentioned technical problems, and the general idea is as follows.

In a first aspect, embodiments of the present application provide a high dielectric liquid crystal polymer composite material. The high dielectric liquid crystal polymer composite material includes liquid crystal polymer (LCP); poly(vinylidene fluoride-co-hexafluoropropylene); modified multi-walled carbon nanotubes; and modified dielectric ceramics;
wherein the modified multi-walled carbon nanotubes include following components metered by mass:
   0.5-2 parts of multi-walled carbon nanotubes; 1∼4 parts of polyvinyl pyrrolidone; and 1.5∼5 parts of a silane coupling agent; and
wherein the modified dielectric ceramics include following components metered by mass:
   10∼20 parts of dielectric ceramics; and 1~2 parts of a dopa-like compound.

The embodiments of the present application provides a high dielectric liquid crystal polymer composite material, which is formed by complexing liquid crystal polymer (LCP) with poly(vinylidene fluoride-co-hexafluoropropylene), modified multi-walled carbon nanotubes and modified dielectric ceramics. Since there is an obvious enhanced synergistic effect between the different fillers, the liquid crystal polymer composite material with both high dielectric properties and low dielectric loss is obtained. Specifically, the organosilane coupling agent improves the compatibility between the multi-walled carbon nanotubes and the matrix, making them evenly dispersed, and reduces the percolation threshold due to grafting of an insulating layer on the surface thereof; since the surface of the dielectric ceramic is coated with a polydopamine layer, the hydrogen bond between the PDA shell and the fluoropolymer greatly enhances the interfacial adhesion of the nanocomposite, meanwhile the Coulomb shielding effect of silver nanoparticles is successfully introduced; and by utilizing the synergy between the two modified fillers, the liquid crystal polymer composite material has the characteristics of low dielectric loss while ensuring high dielectric properties, which effectively solves the technical problem of high dielectric loss in existing high dielectric polymer composite materials.

In the present application, liquid crystal polymer is abbreviated as LCP. Commercial products such as Xydar® G-930 Titan® LG431 Zenite® 7130 Zenite® Vetra® A130, Novaccurate® E335G30; Sumikasuper® and E7000 can be used in the present application.

In the present application, multi-walled carbon nanotubes have the characteristics of high strength and high toughness, and a CAS No. of 308068-56-6.

In the present application, polyvinyl pyrrolidone is abbreviated as PVP, and is a non-ionic polymer compound.

In the present application, dielectric ceramics have the characteristics of high insulation resistivity, small dielectric constant, low dielectric loss, good thermal conductivity, small expansion coefficient, good thermal stability, chemical stability and so on.

In the present application, dopa-like compounds refer to a class of compounds with the characteristic structure of dopa (CAS No. 59-92-7) compound, and may specifically include dopa, dopamine, dopamine hydrochloride, etc.

As an implementation of the embodiments of the present application, the silane coupling agent includes at least one of vinylmethyldimethoxysilane, 3-(methacryloyloxy)propyltrimethoxysilane, and 3 -mercaptopropyltrimethoxysilane.

The present application uses vinylmethyldimethoxysilane, 3-(methacryloyloxy)propyltrimethoxysilane, 3-mercaptopropyltrimethoxysilane and the like as an organosilane coupling agent, which is beneficial to improve the compatibility between the multi-walled carbon nanotubes and the matrix, making them evenly dispersed.

As an implementation of the embodiments of the present application, the dielectric ceramics include at least one of barium titanate, strontium titanate and calcium titanate.

As an implementation of the embodiments of the present application, the dopa-like compound includes at least one of dopa, dopamine and dopamine hydrochloride.

As an implementation of the embodiments of the present application, the liquid crystal polymer is wholly aromatic liquid crystal polymer.

In some specific embodiments of the present application, the liquid crystal polymer (LCP) may be a commercially available wholly aromatic liquid crystal polymer such as Polyplastics A150 Vectra, or may be prepared by a method for preparing a wholly aromatic liquid crystal polymer disclosed in the prior art (Chinese Patent CN200910192087.6).

As an implementation of the embodiments of the present application, the mass ratio of the liquid crystal polymer (LCP), the poly(vinylidene fluoride-co-hexafluoropropylene), the modified multi-walled carbon nanotubes and the modified dielectric ceramics is (20~35):(14~16):(1~4):(10~20).

In the present application, by selecting modified multi-walled carbon nanotubes and modified dielectric ceramics as modified fillers and optimizing the mass ratio of these fillers and the liquid crystal polymer, the liquid crystal polymer composite material with both high dielectric properties and low dielectric loss was prepared. If the amount of any of the above components is adjusted, the dielectric properties will be reduced or the dielectric loss will be increased to a certain extent.

In a second aspect, embodiments of the present application provide a preparation method of the high dielectric liquid crystal polymer composite material of the first aspect, as shown in FIG. 1. The preparation method includes:
obtaining modified multi-walled carbon nanotubes;
obtaining modified dielectric ceramics;
dissolving poly(vinylidene fluoride-co-hexafluoropropylene) into a first solvent to obtain a first solution;
dissolving the modified multi-walled carbon nanotubes and the modified dielectric ceramics into a second solvent to obtain a second solution;
adding the first solution into the second solution and mixing them by stirring to obtain a third solution;
adding the liquid crystal polymer (LCP) into the third solution and mixing them by stirring to obtain a fourth solution; and
washing the fourth solution by adding it into water, then performing drying and hot press molding, so as to obtain the high dielectric liquid crystal polymer composite material.

In some specific embodiments of the present application, the above preparation method may include:
obtaining modified multi-walled carbon nanotubes;
obtaining modified dielectric ceramics; and
dissolving poly(vinylidene fluoride-co-hexafluoropropylene) (P(VDF-HFP)) weighted based on the mass ratio into a first solvent, such as DMF and so on, to obtain a (P(VDF-HFP) solution (i.e., a first solution), meanwhile dispersing modified multi-walled carbon nanotubes and modified dielectric ceramics into a second solvent, such as DMF and so on, to obtain a suspension (i.e., a second solution) by a sonication treatment, adding slowly the P(VDF-HFP) solution into the suspension, and stirring a resulting mixture at room temperature to obtain a mixed solution (i.e., a third solution); after mixing evenly, liquid crystal polymer particles (i.e., the liquid crystal polymer) are added into the mixed solution to obtain a fourth solution; then the fourth solution mixture is poured into a large amount of deionized water, washed repeatedly with the deionized water, dried in a vacuum oven, and finally hot press molded, to prepare into a nanocomposite film, i.e., the high dielectric liquid crystal polymer composite material.

As an implementation of the embodiments of the present application, the obtaining modified multi-walled carbon nanotubes includes specifically:
adding multi-walled carbon nanotubes into a third solvent to obtain a fifth solution;
adding polyvinyl pyrrolidone into a fourth solvent to obtain a sixth solution;
adding the fifth solution into the sixth solution, and then performing sealing and centrifuging operation at room temperature to obtain a first precipitate;
adding a silane coupling agent into a fifth solvent and adjusting pH to 9∼10 to obtain a seventh solution;
adding the first precipitate into the seventh solution, stirring and then centrifuging to obtain a second precipitate; and
washing the second precipitate, and then performing drying and grinding to obtain the modified multi-walled carbon nanotubes.

In some specific embodiments of the present application, the specific process of obtaining the above modified multi-walled carbon nanotubes can be as follows: respectively dispersing/dissolving the multi-walled carbon nanotubes and polyvinyl pyrrolidone weighed based on the ratio into absolute ethanol, adding slowly PVP solution into the multi-walled carbon nanotube solution under stirring, and sealing the resulting mixture at room temperature after completion of the dropwise addition; after reaction, centrifuging and washing the precipitate for three times, wherein the precipitate after centrifuging and washing is labeled as MWCNTs-PVP (i.e., the first precipitate); adding ethanol to a three-necked flask, adjusting pH to 9∼10 with ammonia water, adding the silane coupling agent mixture into the MWCNTs-PVP solution using a constant pressure funnel dropwise, and after reaction, repeating centrifuging and washing for three times to obtain a precipitate labeled as MWCNTs@SiO₂ (i.e., the second precipitate); and drying this precipitate in a vacuum oven and grinding it to obtain multi-walled carbon nanotubes modified by the silane coupling agent (MWCNTs@SiO₂).

As an implementation of the embodiments of the present application, the obtaining modified dielectric ceramics includes specifically:
adding dielectric ceramics into a Tris buffer to obtain an eighth solution;
adding a dopa-like compound into the eighth solution, adjusting pH to 8∼9 and then performing a sonication treatment in an ice bath for 8~15 min to obtain a ninth solution;
stirring the ninth solution at room temperature for 10∼24 h, then performing vacuum suction filtration, washing and drying to obtain dielectric ceramics with core-shell structure;
dispersing the dielectric ceramics with core-shell structure into water, and then performing a sonication treatment in an ice bath for 0.5∼1 h to obtain a tenth solution; and
adding an AgNO₃ solution into the tenth solution, then stirring the resultant in an ice bath for 1∼2 h, and performing centrifuging, washing and drying to obtain the modified dielectric ceramics.

In some specific embodiments of the present application, the specific process of obtaining the above modified dielectric ceramics can be as follows: firstly, preparing a Tris buffer, adding dielectric ceramics into the Tris buffer, and dispersing them by sonication to form a stable suspension. Then a modifier was added, pH was adjusted to 8.5 with dilute HCl, then a sonication treatment was performed in an ice bath, the mixture was vigorously stirred at room temperature (stirring speed > 800 rpm) for reaction, and dielectric ceramics with core-shell structure were obtained after vacuum suction filtration, and washed with deionized water and absolute ethanol for several times. The resulting powder was dried in a vacuum oven. The dielectric ceramics were dispersed in deionized water, then sonicated in an ice bath, and then AgNO₃ solution was added rapidly, and the reaction was performed under vigorous stirring (stirring speed > 800 rpm) in the ice bath. After repeating centrifuging and washing for three times, finally the modified dielectric ceramics are dried under vacuum.

As an implementation of the embodiments of the present application, working parameters of the hot press molding include a temperature of 300°C to 350°C and a pressure of 10 MPa to 15 MPa.

In some specific embodiments of the present application, the working parameters of the hot press molding are preferably a temperature of 310°C and a pressure of 12 MPa.

To sum up, the present application utilizes the synergistic effect between ceramic particles and conductive fillers to prepare the high dielectric liquid crystal polymer composite material. The dielectric ceramics with core-shell structure are obtained by adding different types and amount of the silane coupling agent and grafting with polyvinyl pyrrolidone-multiwall carbon nanotubes, and the dielectric ceramics according to the present application are firstly surface modified by different modifiers, and then embedded with silver nanoparticles on the surface of the polydopamine layer. Finally, the high dielectric liquid crystal polymer composite material is prepared by optimizing the mass ratio of the fillers and the liquid crystal polymer.

The present application will be further described below in conjunction with specific examples.

The experimental methods that do not specify specific conditions in the following examples are usually determined according to national standards. If there is no corresponding national standard, follow the general international standards, conventional conditions, or the conditions suggested by the manufacturer.

### Embodiment 1

The embodiment 1 provides a high dielectric liquid crystal polymer composite material and a preparation method thereof. The preparation method includes:

### (1) a preparation method of modified multi-walled carbon nanotubes (MWCNTs)

0.5 g of MWCNTs and 1 g of PVP were weighed, placed in 50 mL of absolute ethanol, respectively, and dispersed by sonication for 0.5 h. After the multi-walled carbon nanotube solution was completely dispersed, the PVP solution was added slowly into the multi-walled carbon nanotube solution under stirring, and then the mixture was sealed and stirred for 12 h at room temperature after completion of this dropwise addition; after reaction, a precipitate was centrifuged and washed for three times, and the precipitate after centrifugation and washing was labeled as MWCNTs-PVP; 100 ml of ethanol was added into a three-necked flask, and adjusted to pH 9∼10 with ammonia water, and under stirring, 1.5 g of vinylmethyldimethoxysilane mixture was added dropwise into the MWCNTs-PVP solution with a constant pressure funnel, and stirred for 12 h; centrifugation and washing were repeated for three times to obtain a precipitate labeled as MWCNTs@SiO₂; and this precipitate was dried in a 60°C vacuum oven for 10 h and ground to obtain multi-walled carbon nanotubes modified by the silane coupling agent, i.e., MWCNTs@SiO₂.

### (2) a preparation method of modified dielectric ceramics

10 mmol/L Tris buffer was prepared by 200 ml of deionized water, then 10 g of barium titanate was added into the Tris buffer, and ultrasonically dispersed for 3 h to form a stable suspension. Next, 2 g of dopa modifier (specifically dopamine) was added into the suspension, pH value was adjusted to 8.5 with dilute HCl, then a sonication treatment was performed in an ice bath for 10 min, the mixture was vigorously stirred at room temperature for 12 h, and barium titanate with core-shell structure was obtained after vacuum suction filtration, and washed with deionized water and absolute ethanol for several times. The resulting powder (i.e., the barium titanate powder with core-shell structure) was dried in a 60°C vacuum oven for 6 h. 2 g of the barium titanate powder obtained after above drying was dispersed in 95 mL of deionized water, and then sonicated in an ice bath for 0.5 h, then 5 mL AgNO₃ solution (0.5 mol/L) was quickly added, and reacted for 1 h under vigorous stirring in an ice bath. After repeating centrifugation and washing for three times, finally the modified dielectric ceramics was dried under vacuum at 60°C for 24 h.

### (3) a preparation method of high dielectric liquid crystal composite material

15 g of P(VDF-HFP) was dissolved in DMF and stirred at 60°C for 0.5∼1 h. Simultaneously, 1 g of MWCNTs@SiO₂ and 10 g of modified dielectric ceramics were dispersed into another DMF by sonication and vigorously stirred at room temperature for 10 min. The P(VDF-HFP) solution was then slowly added into this suspension, and a resulting mixture was stirred at room temperature for 24 h. After mixing evenly, 25 g of liquid crystal polymer particles (specifically, Polyplastics A150 Vectra) were added into the mixed solution and stirred slowly for 10∼30 min, the mixture was poured into a large amount of deionized water, washed repeatedly with deionized water, dried in a 80°C vacuum oven for 24 h, and finally prepared by hot press molding at 310°C and 12 MPa into a nanocomposite film with a thickness of 30∼40 µm (i.e., the high dielectric liquid crystal polymer composite material) for test use.

### Embodiment 2

The embodiment 2 provides a high dielectric liquid crystal polymer composite material and a preparation method thereof. The preparation method includes:

### (1) a preparation method of modified multi-walled carbon nanotubes (MWCNTs)

1 g of MWCNTs and 2 g of PVP were weighed, placed in 50 mL of absolute ethanol, respectively, and dispersed by sonication for 1 h. After the multi-walled carbon nanotube solution was completely dispersed, the PVP solution was added slowly into the multi-walled carbon nanotube solution under stirring, and then the mixture was sealed and stirred for 24 h at room temperature after completion of this dropwise addition; after reaction, a precipitate was centrifuged and washed for three times, and the precipitate after centrifugation and washing was labeled as MWCNTs-PVP; 100 ml of ethanol was added into a three-necked flask, and adjusted to pH 9∼10 with ammonia water, and under stirring, 2 g of 3-(methacryloyloxy)propyltrimethoxysilane mixture was added dropwise into the MWCNTs-PVP solution with a constant pressure funnel, and stirred for 18 h; centrifugation and washing were repeated for three times to obtain a precipitate labeled as MWCNTs@SiO₂; and this precipitate was dried in a 60°C vacuum oven for 10 h and ground to obtain multi-walled carbon nanotubes modified by the silane coupling agent, i.e., MWCNTs@SiO₂.

### (2) a preparation method of modified dielectric ceramics

10 mmol/L Tris buffer was prepared by 200 ml of deionized water, then 10 g of strontium titanate was added into the Tris buffer, and ultrasonically dispersed for 4 h to form a stable suspension. Next, 2 g of dopamine modifier (specifically dopa) was added into the suspension, pH value was adjusted to 8.5 with dilute HCl, then a sonication treatment was performed in an ice bath for 20 min, the mixture was vigorously stirred at room temperature for 24 h, and then strontium titanate with core-shell structure was obtained after vacuum suction filtration, and washed with deionized water and absolute ethanol for several times. The resulting powder was dried in a 60°C vacuum oven for 6 h. 2 g of the strontium titanate obtained after above drying was dispersed in 95 mL of deionized water, and then sonicated in an ice bath for 1 h, then 10 mL AgNO₃ solution (0.5 mol/L) with a certain Ag⁺ concentration was quickly added, and reacted for 1h under vigorous stirring in an ice bath. After repeating centrifugation and washing for three times, finally the modified strontium titanate was dried under vacuum at 60°C for 24 h.

### (3) a preparation method of high dielectric liquid crystal composite material

15 g of P(VDF-HFP) was dissolved in DMF and stirred at 60°C for 1 h. Simultaneously, 2 g of MWCNTs@SiO₂ and 15 g of modified dielectric ceramics were dispersed in another DMF by sonication and vigorously stirred at room temperature for 10 min. The P(VDF-HFP) solution was then slowly added into this suspension, and a resulting mixture was stirred at room temperature for 24 h. After mixing evenly, 28 g of liquid crystal polymer particles (specifically, Polyplastics A150 Vectra) were added into the mixed solution and stirred slowly for 20 min, the mixture was poured into a large amount of deionized water, washed repeatedly with deionized water, dried in a 80°C vacuum oven for 24 h, and finally prepared by hot press molding at 300°C and 12 MPa into a nanocomposite film with a thickness of 30∼40 µm (i.e., the high dielectric liquid crystal polymer composite material) for test use.

### Embodiment 3

The embodiment 3 provides a high dielectric liquid crystal polymer composite material and a preparation method thereof. The preparation method includes:

### (1) a preparation method of modified multi-walled carbon nanotubes (MWCNTs)

1 g of MWCNTs and 2 g of PVP were weighed, placed in 50 mL of absolute ethanol, respectively, and dispersed by sonication for 1 h. After the multi-walled carbon nanotube solution was completely dispersed, the PVP solution was added slowly into the multi-walled carbon nanotube solution under stirring, and then the mixture was sealed and stirred at room temperature for 18 h after completion of this dropwise addition; after reaction, a precipitate was centrifuged and washed for three times, and the precipitate after centrifugation and washing was labeled as MWCNTs-PVP; 100 ml of ethanol was added into a three-necked flask, and adjusted to pH 9∼10 with ammonia water, and under stirring, 3 g of 3-mercaptopropyltrimethoxysilane mixture was added dropwise into the MWCNTs-PVP solution with a constant pressure funnel, and stirred for 24 h; centrifugation and washing were repeated for three times to obtain a precipitate labeled as MWCNTs@SiO₂; and this precipitate was dried in a 60°C vacuum oven for 10 h and ground to obtain multi-walled carbon nanotubes modified by the silane coupling agent, i.e.,MWCNTs@SiO₂.

### (2) a preparation method of modified dielectric ceramics

10 mmol/L Tris buffer was prepared by 200 ml of deionized water, then 10 g of strontium titanate was added into the Tris buffer, and ultrasonically dispersed for 5 h to form a stable suspension. Next, 2 g of dopamine hydrochloride modifier (specifically dopamine) was added into the suspension, pH value was adjusted to 8.5 with dilute HCl, then a sonication treatment was performed in an ice bath for 20 min, the mixture was vigorously stirred at room temperature for 36 h, and then strontium titanate with core-shell structure was obtained after vacuum suction filtration, and washed with deionized water and absolute ethanol for several times. The resulting powder was dried in a 60°C vacuum oven for 6 h. 2 g of strontium titanate was dispersed in 95 mL of deionized water, and then sonicated in an ice bath for 0.5∼1 h, then 5∼15 mL AgNO₃ solution with a certain Ag⁺ concentration was quickly added, and reacted for 1h under vigorous stirring in an ice bath. After repeating centrifugation and washing for three times, finally the modified strontium titanate was dried under vacuum at 60°C for 24 h.

### (3) a preparation method of high dielectric liquid crystal composite material

15 g of P(VDF-HFP) was dissolved in DMF and stirred at 60°C for 1 h. Simultaneously, 3 g of MWCNTs@SiO₂ and 15 g of modified strontium titanate were dispersed into another DMF by sonication and vigorously stirred at room temperature for 10 min. The P(VDF-HFP) solution was then slowly added into this suspension, and a resulting mixture was stirred at room temperature for 24 h. After mixing evenly, 29 g of liquid crystal polymer particles (specifically, Polyplastics A150 Vectra) were added into the mixed solution and stirred slowly for 30 min, the mixture was poured into a large amount of deionized water, washed repeatedly with deionized water, dried in a 80°C vacuum oven for 24 h, and finally prepared by hot press molding at 330°C and 12 MPa into a nanocomposite film with a thickness of 30∼40 µm (i.e., the high dielectric liquid crystal polymer composite material) for test use.

### Embodiment 4

The embodiment 4 provides a high dielectric liquid crystal polymer composite material and a preparation method thereof. The preparation method includes:

### (1) a preparation method of modified multi-walled carbon nanotubes (MWCNTs)

2 g of MWCNTs and 4 g of PVP were weighed, placed in 50 mL of absolute ethanol, respectively, and dispersed by sonication for 1 h. After the multi-walled carbon nanotube solution was completely dispersed, the PVP solution was added slowly into the multi-walled carbon nanotube solution under stirring, and then the mixture was sealed and stirred for 24 h at room temperature after completion of this dropwise addition; after reaction, a precipitate was centrifuged and washed for three times, and the precipitate after centrifugation and washing was labeled as MWCNTs-PVP; 100 ml of ethanol was added into a three-necked flask, and adjusted to pH 9∼10 with ammonia water, and under stirring, 3 g of 3-mercaptopropyltrimethoxysilane mixture was added dropwise into the MWCNTs-PVP solution with a constant pressure funnel, and stirred for 24 h; centrifugation and washing were repeated for three times to obtain a precipitate labeled as MWCNTs@SiO₂; and this precipitate was dried in a 60°C vacuum oven for 10 h and ground to obtain multi-walled carbon nanotubes modified by the silane coupling agent, i.e., MWCNTs@SiO₂.

### (2) a preparation method of modified dielectric ceramics

10 mmol/L Tris buffer was prepared by 200 ml of deionized water, then 10 g of barium titanate was added into the Tris buffer, and ultrasonically dispersed for 4 h to form a stable suspension. Next, 2 g of dopamine modifier was added into the suspension, pH value was adjusted to 8.5 with dilute HCl, then a sonication treatment was performed in an ice bath for 20 min, the mixture was vigorously stirred at room temperature for 24 h, and then barium titanate with core-shell structure was obtained after vacuum suction filtration, and washed with deionized water and absolute ethanol for several times. The resulting powder was dried in a 60°C vacuum oven for 6 h. 2 g of barium titanate was dispersed in 95 mL of deionized water, and then sonicated in an ice bath for 1 h, then 15 mL AgNO₃ solution (0.5 mol/L) with a certain Ag⁺ concentration was quickly added, and reacted for 1h under vigorous stirring in an ice bath. After repeating centrifugation and washing for three times, finally the modified barium titanate was dried under vacuum at 60°C for 24 h.

### (3) a preparation method of high dielectric liquid crystal composite material

15 g of P(VDF-HFP) was dissolved in DMF and stirred at 60°C for 1 h. Simultaneously, 4 g of MWCNTs@SiO₂ and 20 g of modified barium titanate were dispersed in another DMF by sonication and vigorously stirred at room temperature for 10 min. The P(VDF-HFP) solution was then slowly added into this suspension, and a resulting mixture was stirred at room temperature for 24 h. After mixing evenly, 26 g of liquid crystal polymer particles (specifically, Polyplastics A150 Vectra) were added into the mixed solution and stirred slowly for 30 min, the mixture was poured into a large amount of deionized water, washed repeatedly with deionized water, dried in a 80°C vacuum oven for 24 h, and finally prepared by hot press molding at 330°C and 12 MPa into a nanocomposite film with a thickness of 30∼40 µm (i.e., the high dielectric liquid crystal polymer composite material) for test use.

### Embodiment 5

The embodiment 5 provides a high dielectric liquid crystal polymer composite material and a preparation method thereof. The preparation method includes:

### (1) a preparation method of modified multi-walled carbon nanotubes (MWCNTs)

1 g of MWCNTs and 3 g of PVP were weighed, placed in 50 mL of absolute ethanol, respectively, and dispersed by sonication for 1 h. After the multi-walled carbon nanotube solution was completely dispersed, the PVP solution was added slowly into the multi-walled carbon nanotube solution under stirring, and then the mixture was sealed and stirred at room temperature for 20 h after completion of this dropwise addition; after reaction, a precipitate was centrifuged and washed for three times, and the precipitate after centrifugation and washing was labeled as MWCNTs-PVP; 100 ml of ethanol was added into a three-necked flask, and adjusted to pH 9∼10 with ammonia water, and under stirring, 5 g of 3-(methacryloyloxy)propyltrimethoxysilane mixture was added dropwise into the MWCNTs-PVP solution with a constant pressure funnel, and stirred for 12 h; centrifugation and washing were repeated for three times to obtain a precipitate labeled as MWCNTs@SiO₂; and this precipitate was dried in a 60°C vacuum oven for 10 h and ground to obtain multi-walled carbon nanotubes modified by the silane coupling agent, i.e., MWCNTs@SiO₂.

### (2) a preparation method of modified dielectric ceramics

10 mmol/L Tris buffer was prepared by 200 ml of deionized water, then 20 g of calcium titanate was added into the Tris buffer, and ultrasonically dispersed for 5 h to form a stable suspension. Next, 1 g of dopamine hydrochloride modifier was added into the suspension, pH value was adjusted to 8.5 with dilute HCl, then a sonication treatment was performed in an ice bath for 15 min, the mixture was vigorously stirred at room temperature for 24 h, and then calcium titanate with core-shell structure was obtained after vacuum suction filtration, and washed with deionized water and absolute ethanol for several times. The resulting powder was dried in a 60°C vacuum oven for 6 h. 2 g of calcium titanate was dispersed in 95 mL of deionized water, and then sonicated in an ice bath for 0.5 h, then 10 mL AgNO₃ solution (0.5 mol/L) with a certain Ag⁺ concentration was quickly added, and reacted for 1h under vigorous stirring in an ice bath. After repeating centrifugation and washing for three times, finally the modified dielectric ceramics was dried under vacuum at 60°C for 24 h.

### (3) a preparation method of high dielectric liquid crystal composite material

15 g of P(VDF-HFP) was dissolved in DMF and stirred at 60°C for 0.5 h. Simultaneously, 4 g of MWCNTs@SiO₂ and 5 g of modified calcium titanate were dispersed into another DMF by sonication and vigorously stirred at room temperature for 5 min. The P(VDF-HFP) solution was then slowly added into this suspension, and a resulting mixture was stirred at room temperature for 18 h. After mixing evenly, 27 g of liquid crystal polymer particles (specifically, Polyplastics A150 Vectra) were added into the mixed solution and stirred slowly for 30 min, the mixture was poured into a large amount of deionized water, washed repeatedly with deionized water, dried in a 80°C vacuum oven for 24 h, and finally prepared by hot press molding at 320°C and 12 MPa into a nanocomposite film with a thickness of 30∼40 µm (i.e., the high dielectric liquid crystal polymer composite material) for test use.

### Comparative Example 1

This example provides a high dielectric liquid crystal polymer composite material, the preparation method of which was different from Embodiment 1 only in that: the dielectric ceramics (i.e., barium titanate) were not modified, and the barium titanate was directly used as the raw material for preparing the high dielectric liquid crystal composite material in step (3). The remaining steps and parameters were the same.

### Comparative Example 2

This example provides a high dielectric liquid crystal polymer composite material, the preparation method of which was different from Embodiment 1 only in that: the multi-walled carbon nanotubes were not modified, and the multi-walled carbon nanotubes were directly used as the raw material for preparing the high dielectric liquid crystal composite material in step (3). The remaining steps and parameters were the same.

### Comparative Example 3

This example provides a high dielectric liquid crystal polymer composite material, the preparation method of which was different from Embodiment 1 only in that: in step (3), the amount of modified dielectric ceramics was 25 g, and the amount of modified multi-walled carbon nanotubes was 0.5 g. The remaining steps and parameters were the same.

### Test Example

In this test example, the properties of the liquid crystal polymer composite materials obtained in Embodiments 1-5 and Comparative Examples 1-3 and pure LCP were tested, and the test results are shown in Table 1.

**Table 1**

| Group | Dielectric Constant | Dielectric Loss |
|---|---|---|
| Pure LCP | 2.6∼3.3 | 0.003∼0.004 |
| Embodiment 1 | 56.1 | 0.037 |
| Embodiment 2 | 66.3 | 0.041 |
| Embodiment 3 | 74.7 | 0.046 |
| Embodiment 4 | 92.5 | 0.054 |
| Embodiment 5 | 51.2 | 0.033 |
| Comparative Example 1 | 22.1 | 0.008 |
| Comparative Example 2 | 19.5 | 0.010 |
| Comparative Example 3 | 25.4 | 0.014 |

It is understood that the endpoints of the ranges and any values disclosed herein are not limited to the precise ranges or values, which are understood as encompassing values proximate to those ranges or values. For ranges of values, combination between the endpoints of each range, between the endpoints of each range and the individual point values, and between the individual point values can be made to yield one or more new ranges of values, which should be considered as specifically disclosed herein.

It should be noted that, relational terms as used herein such as "first" and "second" are only used to distinguish one entity or operation from another entity or operation, and do not necessarily require or imply any such actual relationship or sequence that exists between these entities or operations. Moreover, the terms "comprise", "include" or any other variation are intended to encompass non-exclusive inclusion, such that a process, method, article or device comprising a series of elements includes not only those elements, but also other elements not explicitly listed, or also includes elements inherent to such a process, method, article or device. In addition, the term "and/or" as used herein is only an association relationship to describe the associated objects, indicating that there can be three kinds of relationships, for example, as for A and/or B, it can mean three cases where A exists alone, A and B exist at the same time, and B exists alone.

## Claims

1. A high dielectric liquid crystal polymer composite material, **characterized by** comprising: liquid crystal polymer (LCP); poly(vinylidene fluoride-co-hexafluoropropylene); modified multi-walled carbon nanotubes; and modified dielectric ceramics;
wherein the modified multi-walled carbon nanotubes comprise following components metered by mass:
0.5-2 parts of multi-walled carbon nanotubes; 1~4 parts of polyvinyl pyrrolidone; and 1.5-5 parts of a silane coupling agent; and
the modified dielectric ceramics comprise following components metered by mass:
10∼20 parts of dielectric ceramics; and 1∼2 parts of a dopa-like compound.

2. The high dielectric liquid crystal polymer composite material according to claim 1, wherein the silane coupling agent comprises at least one of vinylmethyldimethoxysilane, 3-(methacryloyloxy)propyltrimethoxysilane, and 3-mercaptopropyltrimethoxysilane.

3. The high dielectric liquid crystal polymer composite material according to claim 1, wherein the dielectric ceramics comprise at least one of barium titanate, strontium titanate and calcium titanate.

4. The high dielectric liquid crystal polymer composite material according to claim 1, wherein the dopa-like compound comprises at least one of dopa, dopamine and dopamine hydrochloride.

5. The high dielectric liquid crystal polymer composite material according to claim 1, wherein the liquid crystal polymer is wholly aromatic liquid crystal polymer.

6. The high dielectric liquid crystal polymer composite material according to any one of claims 1-5, wherein a mass ratio of the liquid crystal polymer, the poly(vinylidene fluoride-co-hexafluoropropylene), the modified multi-walled carbon nanotubes and the modified dielectric ceramics is (20-35) : (14-16) : (1-4) : (10-20).

7. A preparation method of the high dielectric liquid crystal polymer composite material according to any one of claims 1-6, **characterized by** comprising:
obtaining modified multi-walled carbon nanotubes;
obtaining modified dielectric ceramics;
dissolving poly(vinylidene fluoride-co-hexafluoropropylene) into a first solvent to obtain a first solution;
dissolving the modified multi-walled carbon nanotubes and the modified dielectric ceramics into a second solvent to obtain a second solution;
adding the first solution into the second solution and mixing by stirring to obtain a third solution;
adding liquid crystal polymer (LCP) into the third solution and mixing by stirring to obtain a fourth solution; and
performing washing the fourth solution by adding the fourth solution into water, then performing drying and hot press molding, so as to obtain the high dielectric liquid crystal polymer composite material.

8. The preparation method of the high dielectric liquid crystal polymer composite material according to claim 7, wherein the obtaining modified multi-walled carbon nanotubes comprises:
adding multi-walled carbon nanotubes into a third solvent to obtain a fifth solution;
adding polyvinyl pyrrolidone (PVP) into a fourth solvent to obtain a sixth solution;
adding the fifth solution into the sixth solution, then performing sealing and centrifuging at room temperature to obtain a first precipitate;
adding a silane coupling agent into a fifth solvent and adjusting pH to 9∼10 to obtain a seventh solution;
adding the first precipitate into the seventh solution, then performing stirring and centrifuging to obtain a second precipitate; and
washing the second precipitate, then performing drying and grinding to obtain the modified multi-walled carbon nanotubes.

9. The preparation method of the high dielectric liquid crystal polymer composite material according to claim 7, wherein the obtaining modified dielectric ceramics comprises:
adding dielectric ceramics into a Tris buffer to obtain an eighth solution;
adding a dopa-like compound into the eighth solution, adjusting pH to 8∼9 and then performing a sonication treatment in an ice bath for 8~15 min to obtain a ninth solution;
stirring the ninth solution at room temperature for 10∼24 h, then performing vacuum suction filtration, washing and drying to obtain dielectric ceramics with core-shell structure;
dispersing the dielectric ceramics with core-shell structure in water, then performing a sonication treatment in an ice bath for 0.5∼1 h to obtain a tenth solution; and
adding an AgNO₃ solution into the tenth solution, then stirring in an ice bath for 1∼2 h, and performing centrifuging, washing and drying to obtain the modified dielectric ceramics.

10. The preparation method of the high dielectric liquid crystal polymer composite material according to claim 7, wherein working parameters of the hot press molding comprise a temperature of 300°C to 350°C and a pressure of 10 MPa to 15 MPa.

## Patentansprüche

1. Hochdielektrisches Flüssigkristallpolymer-Verbundmaterial, **dadurch gekennzeichnet, dass** es Folgendes umfasst: Flüssigkristallpolymer (LCP); Poly(vinylidenfluorid-co-hexafluorpropylen); modifizierte mehrwandige Kohlenstoffnanoröhren; und modifizierte dielektrische Keramiken;
wobei die modifizierten mehrwandigen Kohlenstoffnanoröhren folgende Komponente, die nach Masse dosiert werden, umfassen:
0,5-2 Teile mehrwandige Kohlenstoffnanoröhren; 1-4 Teile Polyvinylpyrrolidon; und 1,5-5 Teile eines Silan-Kupplungsmittels; und
wobei die modifizierten dielektrischen Keramiken folgende Komponente, die nach Masse dosiert werden, umfassen:
10-20 Teile dielektrische Keramiken; und 1-2 Teile einer Dopa-ähnlichen Verbindung.

2. Hochdielektrisches Flüssigkristallpolymer-Verbundmaterial nach Anspruch 1, wobei das Silan-Kupplungsmittel mindestens eines von Vinylmethyldimethoxysilan, 3-(Methacryloyloxy)propyltrimethoxysilan und 3-Mercaptopropyltrimethoxysilan umfasst.

3. Hochdielektrisches Flüssigkristallpolymer-Verbundmaterial nach Anspruch 1, wobei die dielektrischen Keramiken mindestens eines von Bariumtitanat, Strontiumtitanat und Calciumtitanat umfassen.

4. Hochdielektrisches Flüssigkristallpolymer-Verbundmaterial nach Anspruch 1, wobei die Dopa-ähnliche Verbindung mindestens eines von Dopa, Dopamin und Dopaminhydrochlorid umfasst.

5. Hochdielektrisches Flüssigkristallpolymer-Verbundmaterial nach Anspruch 1, wobei das Flüssigkristallpolymer ein vollständig aromatisches Flüssigkristallpolymer ist.

6. Hochdielektrisches Flüssigkristallpolymer-Verbundmaterial nach einem der Ansprüche 1-5, wobei das Massenverhältnis des Flüssigkristallpolymers, des Poly(vinylidenfluorid-co-hexafluorpropylen), der modifizierten mehrwandigen Kohlenstoffnanoröhren und der modifizierten dielektrischen Keramik (20-35): (14-16): (1-4): (10-20) beträgt.

7. Verfahren zur Herstellung des hochdielektrischen Flüssigkristallpolymer-Verbundmaterials nach einem der Ansprüche 1 bis 6, **dadurch gekennzeichnet, dass** es umfasst:
Erhalten modifizierter mehrwandiger Kohlenstoffnanoröhren;
Erhalten modifizierter dielektrischer Keramiken;
Auflösen von Poly(vinylidenfluorid-co-hexafluoropropylen) in einem ersten Lösungsmittel, um eine erste Lösung zu erhalten;
Auflösen der modifizierten mehrwandigen Kohlenstoffnanoröhren und der modifizierten dielektrischen Keramiken in einem zweiten Lösungsmittel, um eine zweite Lösung zu erhalten;
Hinzufügen der ersten Lösung zur zweiten Lösung und Mischen durch Rühren, um eine dritte Lösung zu erhalten;
Hinzufügen von Flüssigkristallpolymer (LCP) zur dritten Lösung und Mischen durch Rühren, um eine vierte Lösung zu erhalten; Und
Durchführen eines Waschens der vierten Lösung durch Hinzufügen der vierten Lösung zu Wasser, anschließendes Trocknen und Heißpressen, um das hochdielektrische Flüssigkristallpolymer-Verbundmaterial zu erhalten.

8. Verfahren zur Herstellung des hochdielektrischen Flüssigkristallpolymer-Verbundmaterials nach Anspruch 7, wobei das Erhalten modifizierter mehrwandiger Kohlenstoffnanoröhren umfasst:
Hinzufügen von mehrwandigen Kohlenstoffnanoröhren zu einem dritten Lösungsmittel, um eine fünfte Lösung zu erhalten;
Hinzufügen von Polyvinylpyrrolidon (PVP) zu einem vierten Lösungsmittel, um eine sechste Lösung zu erhalten;
Hinzufügen der fünften Lösung zur sechsten Lösung, anschließendes Versiegeln und Zentrifugieren bei Raumtemperatur, um einen ersten Niederschlag zu erhalten;
Hinzufügen eines Silan-Kupplungsmittels zu einem fünften Lösungsmittel und Einstellen des pH-Werts auf 9-10, um eine siebte Lösung zu erhalten;
Hinzufügen des ersten Niederschlags zur siebten Lösung und anschließendes Rühren und Zentrifugieren, um einen zweiten Niederschlag zu erhalten; und
Waschen des zweiten Niederschlags, anschließendes Trocknen und Mahlen, um die modifizierten mehrwandigen Kohlenstoffnanoröhren zu erhalten.

9. Verfahren zur Herstellung des hochdielektrischen Flüssigkristallpolymer-Verbundmaterials nach Anspruch 7, wobei das Erhalten modifizierter dielektrischer Keramik Folgendes umfasst:
Hinzufügen von dielektrischen Keramiken zu einem Tris-Puffer, um eine achte Lösung zu erhalten;
Hinzufügen einer Dopa-ähnlichen Verbindung zur achten Lösung, Einstellen des pH-Werts auf 8-9 und anschließendes Durchführen einer Ultraschallbehandlung in einem Eisbad für 8-15 Minuten, um eine neunte Lösung zu erhalten;
Rühren der neunten Lösung bei Raumtemperatur für 10-24 Stunden, dann Durchführung einer Vakuumsaugfiltration, Waschen und Trocknen, um dielektrische Keramiken mit Kern-Schale-Struktur zu erhalten;
Dispergieren der dielektrischen Keramik mit Kem-Schale-Struktur in Wasser, dann Durchführen einer Beschallungsbehandlung in einem Eisbad für 0,5∼1 h, um eine zehnte Lösung zu erhalten; und
Hinzufügen einer AgNO₃-Lösung zur zehnten Lösung, anschließendes Rühren in einem Eisbad für 1-2 Stunden und Zentrifugieren, Waschen und Trocknen, um die modifizierte dielektrische Keramik zu erhalten.

10. Verfahren zur Herstellung des hochdielektrischen Flüssigkristallpolymer-Verbundmaterials nach Anspruch 7, wobei die Arbeitsparameter des Heißpressens eine Temperatur von 300°C bis 350°C und einen Druck von 10 MPa bis 15 MPa umfassen.

## Revendications

1. Matériau composite polymère à cristaux liquides à haute constante diélectrique, **caractérisé en ce qu'**il comprend un polymère à cristaux liquides (LCP) ; poly(fluorure de vinylidène-co-hexafluoropropylène) ; des nanotubes de carbone modifiés à multi-paroi ; et une céramique diélectrique modifié ;
dans lequel les nanotubes de carbone modifiés à multi-paroi comprennent les composants suivants exprimés en masse :
0,5 à 2 parts de nanotubes de carbone à multi-paroi ; 1 à 4 parts de polyvinyle pyrrolidone ; et 1,5 à 5 parts d'un agent de couplage de silane ; et
la céramique diélectrique modifié comprennent les composants suivants exprimés en masse :
10-20 parts de céramique diélectrique ; et 1 à 2 parts d'un composé de type dopa.

2. Matériau composite polymère à cristaux liquides à haute constante diélectrique selon la revendication 1, dans lequel l'agent de couplage silane comprend au moins un parmi le vinylméthyldiméthoxy silane, le 3-(méthacryloyloxy)propyltriméthoxysilane et le 3-mercaptopropyltriméthoxysilane.

3. Matériau composite polymère à cristaux liquides à haute constante diélectrique selon la revendication 1, dans lequel la céramique diélectrique comprend au moins une parmi le titanate de baryum, le titanate de strontium et le titanate de calcium.

4. Matériau composite polymère à cristaux liquides à haute constante diélectrique selon la revendication 1, dans lequel le composé de type dopa comprend au moins un parmi un composé de dopa, la dopamine et le chlorhydrate de dopamine.

5. Matériau composite polymère à cristaux liquides à haute constante diélectrique selon la revendication 1, dans lequel le polymère à cristaux liquides est un polymère à cristaux liquides entièrement aromatique.

6. Matériau composite polymère à cristaux liquides à haute constante diélectrique selon l'une quelconque des revendications 1 à 5, dans lequel un rapport massique entre le polymère à cristaux liquides, le poly(fluorure de vinylidène-co-hexafluoropropylène), les nanotubes de carbone modifiés à multi-paroi et la céramique diélectrique modifié est de (20-35) : (14-16) : (1-4) : (10-20).

7. Procédé de préparation du matériau composite polymère à cristaux liquides à haute constante diélectrique selon l'une quelconque des revendications 1 à 6, **caractérisé en ce qu'**il comprend les étapes suivantes :
obtenir des nanotubes de carbone modifiés à multi-paroi ;
obtenir une céramique diélectrique modifié ;
dissoudre le poly(fluorure de vinylidène-co-hexafluoropropylène) dans un premier solvant pour obtenir une première solution ;
dissoudre les nanotubes de carbone modifiés à multi-paroi et la céramique diélectrique modifié dans un deuxième solvant pour obtenir une deuxième solution ;
ajouter la première solution à la deuxième solution et mélanger sous agitation pour obtenir une troisième solution ;
ajouter un polymère à cristaux liquides (LCP) à la troisième solution et mélanger sous agitation pour obtenir une quatrième solution ; et
effectuer un lavage sur la quatrième solution en ajoutant la quatrième solution à l'eau, puis effectuer un séchage et un moulage sous pression à chaud, afin d'obtenir le matériau composite polymère à cristaux liquides à haute constante diélectrique.

8. Procédé de préparation du matériau composite polymère à cristaux liquides à haute constante diélectrique selon la revendication 7, dans lequel l'étape d'obtenir des nanotubes de carbone modifiés à multi-paroi comprend :
ajouter les nanotubes de carbone à multi-paroi à un troisième solvant pour obtenir une cinquième solution ;
ajouter le polyvinyle pyrrolidone (PVP) à un quatrième solvant pour obtenir une sixième solution ;
ajouter la cinquième solution à la sixième solution, puis effectuer un scellage et une centrifugation à température ambiante pour obtenir un premier précipité ;
ajouter un agent de couplage de silane à un cinquième solvant et ajuster le pH à 9-10 pour obtenir une septième solution ;
ajouter le premier précipité dans la septième solution, puis effectuer une agitation et une centrifugation pour obtenir un second précipité ; et
laver le second précipité, puis effectuer un séchage et un broyage pour obtenir les nanotubes de carbone modifiés à multi-paroi.

9. Procédé de préparation du matériau composite polymère à cristaux liquides à haute constante diélectrique selon la revendication 7, dans lequel l'étape d'obtenir une céramique diélectrique modifié comprend :
ajouter une céramique diélectrique à un tampon Tris pour obtenir une huitième solution ;
ajouter un composé de type dopa à la huitième solution, ajuster le pH à 8-9, puis effectuer un traitement de sonication dans un bain de glace pendant 8 à 15 min pour obtenir une neuvième solution ;
agir la neuvième solution à température ambiante pendant 10 à 24 h, puis effectuer une filtration par extraction sous vide, laver et sécher pour obtenir une céramique diélectrique à une structure noyau-coquille ;
disperser la céramique diélectrique à une structure noyau-coquille dans l'eau, puis effectuer un traitement de sonication dans un bain de glace pendant 0,5 à 1 h pour obtenir une dixième solution ; et
ajouter une solution d'AgNO₃ à la dixième solution, puis agiter dans un bain de glace pendant 1 à 2 h, et effectuer une centrifugation, laver et sécher pour obtenir la céramique diélectrique modifié.

10. Procédé de préparation du matériau composite polymère à cristaux liquides à haute constante diélectrique selon la revendication 7, dans lequel des paramètres de fonctionnement du moulage sous pression à chaud comprennent une température de 300°C à 350°C et une pression de 10 MPa à 15 MPa.
